# EUROPEAN PATENT APPLICATION

(11) **EP 3 456 683 A1**
(43) Date of publication of application: **20.03.2019**
(21) Application number: 18158581.1
(22) Date of filing: 26.02.2018
(51) Int. Cl.: B81C 1/00, H01L 23/532

(54) **CONNECTION STRUCTURE AND MANUFACTURING METHOD THEREOF, AND SENSOR**

(30) Priority: 15.09.2017 JP 2017178170
(71) Applicant: KABUSHIKI KAISHA TOSHIBA, Minato-ku Tokyo 105-8001 (JP)
(72) Inventor: Tomizawa, Hideyuki, Tokyo, 105-8001 (JP); Saito, Tomohiro, Tokyo, 105-8001 (JP); Fujimoto, Akira, Tokyo, 105-8001 (JP); Kurui, Yoshihiko, Tokyo, 105-8001 (JP); Kojima, Akihiro, Tokyo, 105-8001 (JP)
(74) Representative: Hoffmann Eitle

(57) **Abstract**

According to one arrangement, a connection structure is disclosed. The connection structure includes a plug (20) having conductivity, a first insulating film (21, 22), and an electrode (24). The first insulating film (21, 22) covers a side surface of the plug (20). The electrode (24) is provided on an upper surface of the plug (20), and includes a polycrystalline silicon germanium layer (25) and an amorphous silicon germanium layer (26). The polycrystalline silicon germanium layer (25) is in contact with at least part of the upper surface of the plug (20) without an intervention the amorphous silicon germanium layer (26).

## Description

### FIELD

The present disclosure relates to a connection structure between a plug and a silicon germanium layer, a manufacturing method thereof, and a sensor.

### BACKGROUND

As a semiconductor material other than silicon, silicon germanium is known. A micro-electromechanical systems (MEMS) device is an example of a device that employs a layer containing silicon germanium.

### BRIEF DESCRIPTION OF THE DRAWINGS

FIG. 1 is a cross-sectional view illustrating a connection structure according to a first arrangement.
FIG. 2 is a cross-sectional view for explaining a method of manufacturing the connection structure according to the first arrangement.
FIG. 3 is a cross-sectional view for explaining the method of manufacturing the connection structure according to the first arrangement subsequent to FIG. 2.
FIG. 4 is a cross-sectional view for explaining the method of manufacturing the connection structure according to the first arrangement subsequent to FIG. 3.
FIG. 5 is a cross-sectional view for explaining the method of manufacturing the connection structure according to the first arrangement subsequent to FIG. 4.
FIG. 6 is a cross-sectional view for explaining the method of manufacturing the connection structure according to the first arrangement subsequent to FIG. 5.
FIG. 7 is a cross-sectional view for explaining the method of manufacturing the connection structure according to the first arrangement subsequent to FIG. 6.
FIG. 8 is a cross-sectional view for explaining the method of manufacturing the connection structure according to the first arrangement subsequent to FIG. 7.
FIG. 9 is a cross-sectional view for explaining the method of manufacturing the connection structure according to the first arrangement subsequent to FIG. 8.
FIG. 10 is a cross-sectional view illustrating a connection structure according to a second arrangement.
FIG. 11 is a cross-sectional view for explaining a method of manufacturing the connection structure according to the second arrangement.
FIG. 12 is a cross-sectional view for explaining the method of manufacturing the connection structure according to the second arrangement subsequent to FIG. 11.
FIG. 13 is a cross-sectional view for explaining the method of manufacturing the connection structure according to the second arrangement subsequent to FIG. 12.
FIG. 14 is a cross-sectional view illustrating a connection structure according to a third arrangement.
FIG. 15 is a cross-sectional view illustrating a connection structure according to a fourth arrangement.
FIG. 16 is a cross-sectional view for explaining a method of manufacturing the connection structure according to the fourth arrangement.
FIG. 17 is a cross-sectional view for explaining the method of manufacturing the connection structure according to the fourth arrangement subsequent to FIG. 16.
FIG. 18 is a cross-sectional view for explaining the method of manufacturing the connection structure according to the fourth arrangement subsequent to FIG. 17.
FIG. 19 is a cross-sectional view for explaining the method of manufacturing the connection structure according to the fourth arrangement subsequent to FIG. 18.
FIG. 20 is a cross-sectional view for explaining the method of manufacturing the connection structure according to the fourth arrangement subsequent to FIG. 19.
FIGS. 21A and 21B are a plane view and a cross-sectional view illustrating a connection structure according to a fifth arrangement.
FIG. 22 is a cross-sectional view illustrating a connection structure according to a sixth arrangement.
FIG. 23 is a cross-sectional view schematically illustrating an acceleration sensor according to a seventh arrangement.
FIG. 24 is a plane view illustrating a MEMS capacitor.
FIGS. 25A and 25B are cross-sectional views each schematically illustrating a connection structure between a fixed electrode and a plug.
FIG. 26 is a cross-sectional view for explaining a method of manufacturing the acceleration sensor according to the seventh arrangement.
FIG. 27 is a cross-sectional view for explaining the method of manufacturing the connection structure according to the fourth arrangement subsequent to FIG. 26.
FIG. 28 is a cross-sectional view for explaining the method of manufacturing the connection structure according to the fourth arrangement subsequent to FIG. 27.
FIG. 29 is a cross-sectional view for explaining the method of manufacturing the connection structure according to the fourth arrangement subsequent to FIG. 28.
FIG. 30 is a cross-sectional view for explaining the method of manufacturing the connection structure according to the fourth arrangement subsequent to FIG. 29.
FIG. 31 is a cross-sectional view for explaining the method of manufacturing the connection structure according to the fourth arrangement subsequent to FIG. 30.
FIG. 32 is a cross-sectional view for explaining the method of manufacturing the connection structure according to the fourth arrangement subsequent to FIG. 31.
FIG. 33 is a cross-sectional view for explaining the method of manufacturing the connection structure according to the fourth arrangement subsequent to FIG. 32.
FIG. 34 is a cross-sectional view for explaining the method of manufacturing the connection structure according to the fourth arrangement subsequent to FIG. 33.
FIG. 35 is a cross-sectional view illustrating a MEMS capacitor of a MEMS device to which the connection structure according to the fourth arrangement is applied.

### DETAILED DESCRIPTION

In general, according to one arrangement, a connection structure is disclosed. The connection structure includes a plug having conductivity, a first insulating film, and an electrode. The first insulating film covers a side surface of the plug. The electrode is provided on an upper surface of the plug, and includes a polycrystalline silicon germanium layer and an amorphous silicon germanium layer. The polycrystalline silicon germanium layer is in contact with at least part of the upper surface of the plug without an intervention the amorphous silicon germanium layer.

According to another arrangement, a method of manufacturing a connection structure is disclosed. An intermediate insulating film, and an upper insulating film are sequentially formed on a lower insulating film. A first through hole is formed in the lower insulating film, the intermediate insulating film and the upper insulating film. A plug is formed in the first through hole. An amorphous silicon germanium layer is formed on the upper insulating film and the plug. A second through hole is formed in the amorphous silicon germanium layer such that the second through hole is communicated with the first plug. A polycrystalline silicon germanium layer is formed on the plug and the amorphous silicon germanium layer such that the polycrystalline silicon germanium layer fills the second through hole.

According to yet another arrangement, a sensor is disclosed. The sensor includes a variable capacitance element, a circuit, a plug having conductivity, an insulating film, and a connection structure. The variable capacitance element includes a first electrode and a second electrode. The circuit senses a predetermined physical property by detecting a variation of capacitance between the first electrode and the second electrode. The plug connects the circuit and the variable capacitance element each other. The insulating film covers a side surface of the plug. The connection structure connects the first electrode and the plug each other, and includes a connection structure of an arrangement.

Arrangements will be described hereinafter with reference to the accompanying drawings. The drawings are schematic and conceptual, and the dimensions, the proportions, etc., of each of the drawings are not necessarily the same as those in reality. Further, in the drawings, the same reference symbols denote the same or corresponding portions, and overlapping explanations thereof will be made as necessary. In addition, as used in the description and the appended claims, what is expressed by a singular form shall include the meaning of "more than one."

### (First Arrangement)

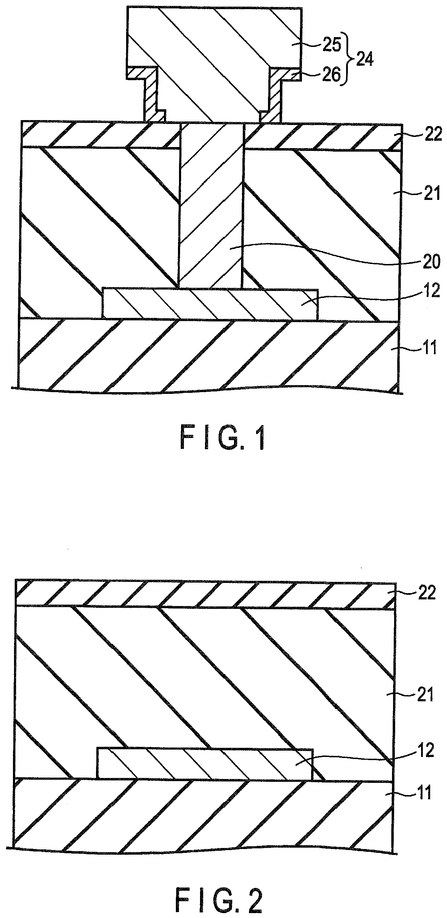

FIG. 1 is a cross-sectional view illustrating a connection structure according to the first arrangement, and more particularly depicting a cross-sectional view of a plug 20 having conductivity and an electrode 24 which is provide on the plug 20 and contains silicon germanium.

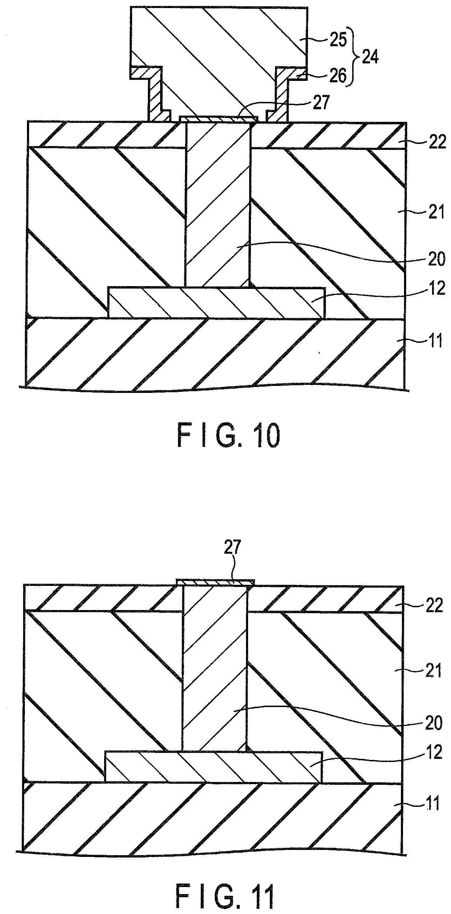

In FIG. 1, 11 denotes an interlayer insulating film provided on a semiconductor substrate (not shown), and an interconnection 12 is provided on the interlayer insulating film 11. For example, the silicon substrate is a silicon substrate, the interlayer insulating film is a silicon oxide film, and the interconnection is an aluminum interconnection.

A method of forming the aluminum interconnection includes a process of forming an aluminum film on the interlayer insulating film 11, a process of forming a resist pattern on the aluminum film, a process of etching the aluminum film by reactive ion etching process (RIE) using the resist pattern as a mask. The interconnection 12 may employ a stuck structure of an aluminum interconnection and a barrier metal film. The barrier metal film is, for example, a titanium film, or a stacked film of a nitride titanium film and a titanium film. The titanium film is stacked on the nitride titanium film. The interconnection 12 may be a copper interconnection. The copper interconnection is formed by using, for example, a damascene process.

The plug 20 is provided on the interconnection 12. The plug 20 is electrically connected to the interconnection 12. The side surface of the plug 20 is covered with an interlayer insulating film (lower insulating film) 21 and an interlayer insulating film (upper insulating film) 21. More specifically, the side surface of the upper portion side of the plug 20 is covered with the interlayer insulating film 22, and the side surface of the other side (lower portion side) of the interlayer insulating film 22 is covered with the interlayer insulating film 21. The interlayer insulating film 21 and the interlayer insulating film 22 are insulating films of different type, and for example, the interlayer insulating film 21 is a silicon oxide film, and the interlayer insulating film 22 is a silicon nitride film or a silicon carbide film. The upper surface of the plug 20 is not covered with the interlayer insulating film 21 nor the interlayer insulating film 22.

The electrode 24 is provided on the upper surface of the plug 20. The electrode 24 includes a polycrystalline silicon germanium layer 25 and an amorphous silicon germanium layer 26. The amorphous silicon germanium layer 26 is provide under the polycrystalline silicon germanium layer 25. The polycrystalline silicon germanium layer 25 may contain dopants.

The ratio of silicon and germanium (Si/Ge ratio) of the polycrystalline silicon germanium layer 25 is in a range from 25/75 to 35/65, for example. The Si/Ge ratio of the amorphous silicon germanium layer 26 is also in the range from 25/75 to 35/65, for example. The Si/Ge ratio of the polycrystalline silicon germanium layer 25 may be same as or may be different from the Si/Ge ratio of the amorphous silicon germanium layer 26.

In the present arrangement, the polycrystalline silicon germanium layer 25 is directly in contact with an entire upper surface of the plug 20. The area of the lower surface of the polycrystalline silicon germanium layer 25 is greater than the area of the upper surface of the plug 20. The amorphous silicon germanium layer 26 does not overlap with the upper surface of the plug 20.

The resistivity of the amorphous silicon germanium layer is greater than the resistivity of the polycrystalline silicon germanium layer. For example, the resistivity of the amorphous silicon germanium having about 100 nm thickness is 1.00 X 10 Ω·cm, and the resistivity of the polycrystalline silicon germanium having about 5 to 20 µm thickness is 3.38 X 10⁻³ Ω·cm.

For that reason, the structure in which the amorphous silicon germanium layer 26 is directly in contact with the entire upper surface of the plug 20, and the polycrystalline silicon germanium layer 25 is indirectly in contact with the entire upper surface of the plug through the amorphous silicon germanium layer 26 (connection structure of a comparative example) has a high contact resistance between the plug 20 and the electrode 24. The contact resistance of the connection structure of the comparative example is, for example, 5.1 KΩ.

On the other hand, the connection structure according to the present arrangement is directly in contact with the entire upper surface of the plug, so that the contact resistance between the plug 20 and the electrode 24 is low. For example, the contact resistance is 17 Q. Hereafter, the connection structure of the present arrangement will be further described in accordance with manufacturing processes thereof.

FIGS. 2 to 9 are cross-sectional views for explaining the manufacturing method of the connection structure between the plug 20 and the electrode 24 of the present arrangement.

First, as shown FIG. 2, the interconnection 12 is formed on the interlayer insulating film 11, following that, the interlayer insulating film 21 is formed on the interlayer insulating film 11 such that the interlayer insulating film 21 covers the interconnection 12, and then the surface of the interlayer insulating film 21 is planarized by chemical mechanical polishing (CMP). After that, the interlayer insulating film 22 is formed on the interlayer insulating film 21. The interlayer insulating film 22 is thinner than the interlayer insulating film 21. In the present manufacturing method, silicon oxide films are used as the interlayer insulating films 11 and 12, and an silicon nitride film is used as the interlayer insulating film 22.

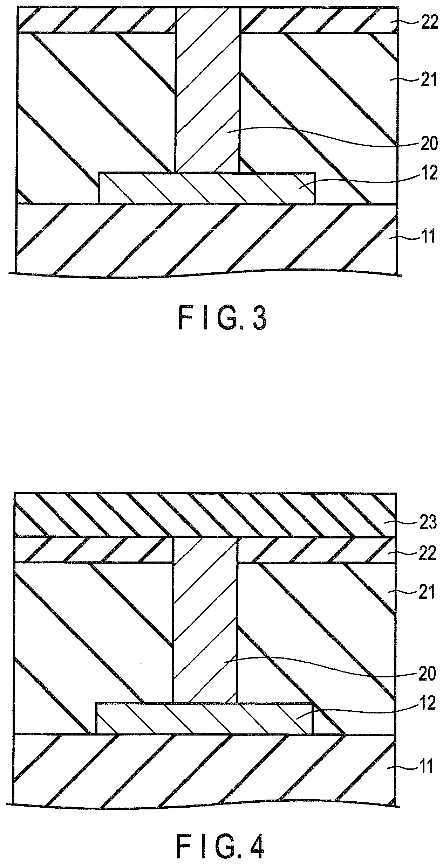

Subsequently, as shown FIG. 3, the interlayer insulating film 22 and the interlayer insulating film 21 are sequentially etched to form a through hole (not shown) that communicates with the interconnection 12, after that the plug 20 is formed to fill the through hole. In this manner, the structure in which the side surface of the plug 20 is covered with the interlayer insulating films 21 and 22, and the upper surface of the plug 20 is not covered with the interlayer insulating films 21 and 22 is obtained. In FIG. 3, the side surface of the plug 20 is directly covered with interlayer insulating films 21 and 22.

A forming method of the plug includes, for example, a process of depositing a tungsten film to be processed into the plug 20 on the entire surface such that the tungsten film fill the through hole, a process of planarizing the surface of the tungsten film and the surface of the interlayer insulating film 22 by CMP process. The upper surface of the plug 20 and the upper surface of the interlayer insulating film 2 form a flat surface.

It is noted that a conductive film other than the tungsten film may be used. For example, a copper film may be used. In this case, for example, the plug (copper) 20 is formed in the through hole after the bottom surface and the side surface of the through hole is covered with a barrier metal film. Consequently, the side surface of the plug 20 is indirectly covered with interlayer insulating films 21 and 22 through the barrier metal film. The barrier metal film is, for example, a stacked film of a titanium nitride film and a titanium film. The titanium nitride film is arranged between the side surface of the plug 20 and the titanium film.

Subsequently, as shown in FIG. 4, the interlayer insulating film 23 is formed on the plug 20 and the interlayer insulating film 22. In the present arrangement, the interlayer insulating film 23 is a silicon oxide film which is used as a sacrifice film.

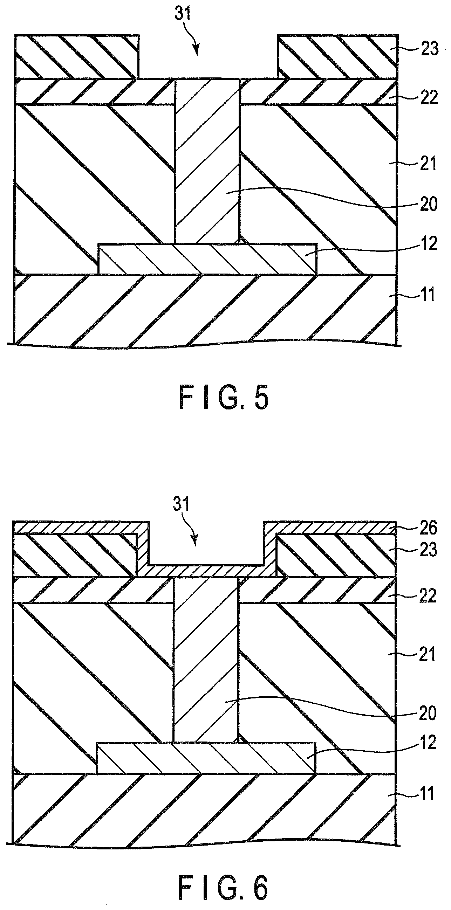

Subsequently, as shown in FIG. 5, the interlayer insulating film 23 is patterned by using photolithography process and etching process to form a through hole 31 in the interlayer insulating film 23 such that the through hole 31 exposes the upper surface of the plug 20 and a surface of the interlayer insulating film 22 near the periphery of the upper surface of the plug 20.

Subsequently, as shown in FIG. 6, the amorphous silicon germanium layer 26 is formed by chemical vapor deposition (CVD) process such that the amorphous silicon germanium layer 26 covers the bottom and side surfaces of the through hole 31, and the upper surface of the interlayer insulating film 23.

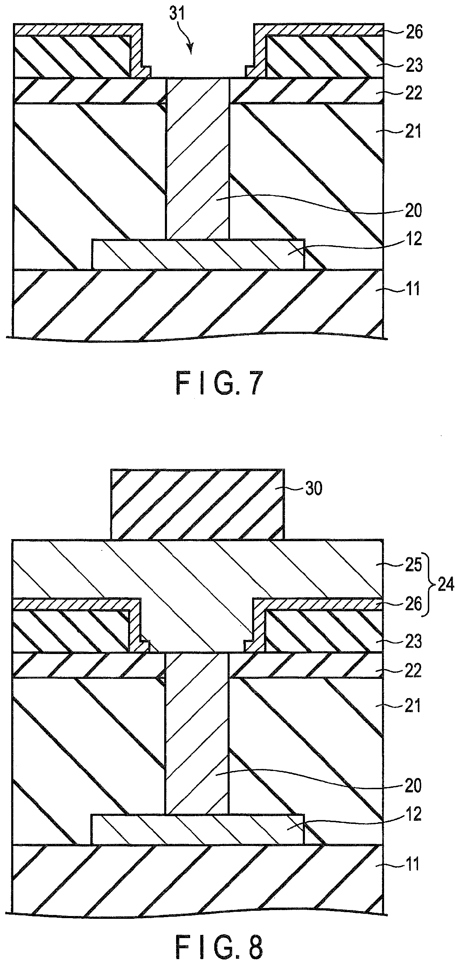

Subsequently, as shown in FIG. 7, the amorphous silicon germanium layer 26 is patterned by using photolithography process and etching process to expose the upper surface of the plug 20 and the surface of the interlayer insulating film 22 near the periphery of the upper surface of the plug 20.

Subsequently, as shown in FIG. 8, a polycrystalline silicon germanium layer 25 is formed to fill the through hole 31 that is shown in FIG. 7, after that a hard mask 30 made of silicon oxide is formed on the polycrystalline silicon germanium layer 25. The polycrystalline silicon germanium layer 25 is formed by CVD process in which the amorphous silicon germanium layer 26 is used as a seed layer. By doing this, the polycrystalline silicon germanium layer 25 can be formed to fill the through hole 31 that is shown in FIG. 7.

The polycrystalline silicon germanium layer 25 and the amorphous silicon germanium layer 26 are formed by CVD process, but the conditions (e.g., pressure or source gas) of the CVD process to form the polycrystalline silicon germanium layer 25 are different from the conditions (e.g., pressure or source gas) of the CVD process to form the amorphous silicon germanium layer 26, so that both the polycrystalline and amorphous silicon germanium layers 25 and 26 can be formed by CVD process.

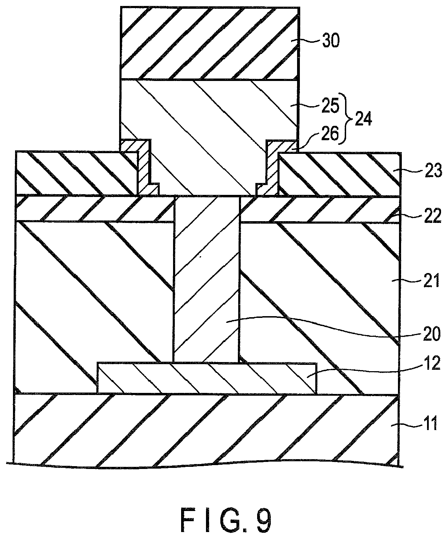

Subsequently, as shown in FIG. 9, an electrode 24 is formed by sequentially etching the polycrystalline silicon germanium layer 25 and the amorphous silicon germanium layer 26 by using the hard mask as a mask.

After that, the insulating film (sacrifice film) 23 is removed by dry process using hydrogen fluoride gas (HF gas), thereby obtaining the connection structure that is shown in FIG. 1.

A modification example of the present arrangement is illustrated in FIG. 9, in which the interlayer insulating film 23 is not removed, and thus remained. The connection structure of the modification example includes an electrode 24 penetrating through the interlayer insulating film 23 and is in contact with the upper surface of the plug 20.

### (Second Arrangement)

FIG. 10 is a cross-sectional view illustrating a connection structure according to the second arrangement.

The present arrangement is different from the first arrangement in that a barrier metal film (conductive film) 27 is employed. The barrier metal film 27 covers the entire upper surface of the plug. In the present arrangement, the polycrystalline silicon germanium layer 25 is indirectly in contact with the entire surface of the plug through the barrier metal film 27.

Hereafter, the connection structure according to the present arrangement will be further explained in accordance with a manufacturing method of the connection structure.

After the process shown in FIG. 3 of the first arrangement, a conductive film (e.g., a titanium film) to be processed into the barrier metal film 27 is formed on the plug 20 and the interlayer insulating film 22, and then the conductive film is patterned to form the barrier metal film 27 as shown in FIG. 11. The barrier metal film 27 is formed to cover the upper surface of the plug 20 and the surface of the interlayer insulating film 22 near the periphery of the upper surface of the plug 20.

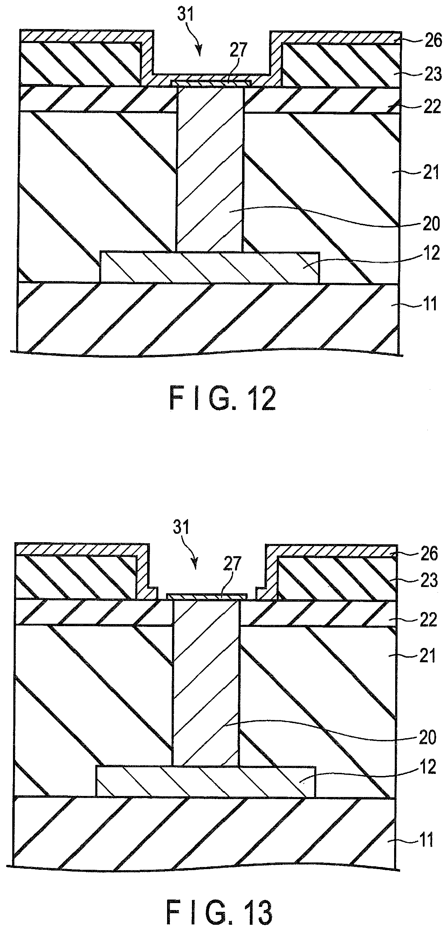

Subsequently, as shown in FIG. 12, the interlayer insulating film 23 having a through hole 31 is formed on the interlayer insulating film 22, and then the amorphous silicon germanium layer 26 is formed to cover the bottom surface and the side surface of the through hole 31.

A method of forming the interlayer insulating film 23 having the through hole 31 includes, for example, a process of forming an insulating film to be processed into the interlayer insulating film 23 on the interlayer insulating film 22 and the barrier metal film 27, a process of forming the through hole 31 by patterning the insulating film by using photolithography process and etching process.

Subsequently, as shown in FIG. 13, the amorphous silicon germanium layer 26 is pattered by using photolithography process and etching process, thereby exposing the barrier metal film 27, and the surface of the interlayer insulating film 22 near the periphery of the barrier metal film 27.

The upper surface of the plug is covered by the barrier metal film 27, so that damage of the upper surface of the plug caused by the etching process (etching damage) is reduced. Thereby suppressing increase of contact resistance between the plug 20 and the electrode 24 due to the etching damage.

In addition, even if a seam (not shown) communicated with the upper surface of the plug 20, or a void (not shown) in the plug is generated, the increase of contact resistance between the plug 20 and the electrode 24 due to the seam or the void is suppressed since the surface of the plug is covered with the barrier metal film 27.

After the process shown in FIG. 13, the processes shown in FIG. 8 and subsequent drawings are performed similarly as the first arrangement, and thus the connection structure shown in FIG. 10 is obtained.

As a modification of the present arrangement, the interlayer insulating film 23 may be remained similarly to the modification of the first arrangement.

### (Third Arrangement)

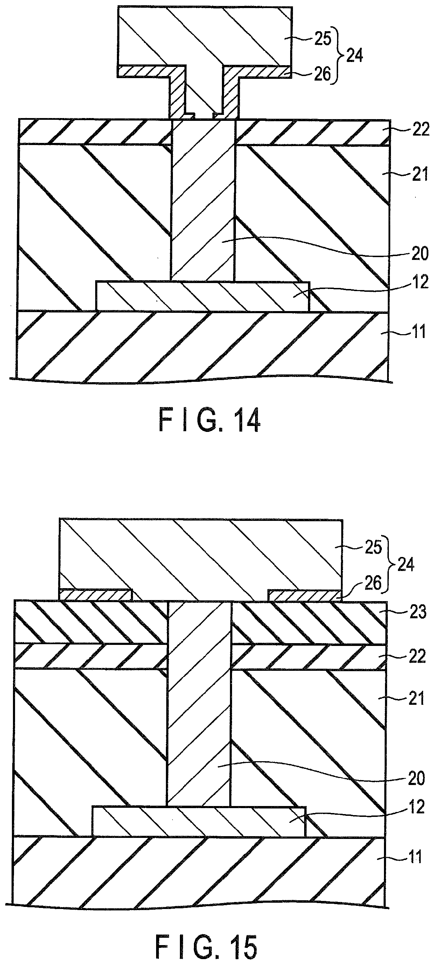

FIG. 14 is a cross-sectional view illustrating a connection structure according to the third arrangement.

The present arrangement is different from the first arrangement in that the polycrystalline silicon germanium layer 25 is not directly in contact with the entire upper surface of the plug 20 but is directly in contact with a part of the upper surface of the plug 20. More particularly, the polycrystalline silicon germanium layer 25 is in contact with a central portion of the upper surface of the plug 20. The amorphous silicon germanium layer 26 is directly in contact with the other portion the upper surface of the plug 20. From the point of reducing the contact resistance, the contact area between the polycrystalline silicon germanium layer 25 and the plug 20 is preferably greater than the contact area between the amorphous silicon germanium layer 26 and the plug 20.

In order to obtain the connection structure of the third arrangement, for example, in the process of FIG. 7, the amorphous silicon germanium layer 26 is patterned such that the central portion of the amorphous silicon germanium layer 26 is exposed.

As a modification of the present arrangement, the interlayer insulating film 23 may be remained similarly to the modification of the first arrangement.

### (Fourth Arrangement)

FIG. 15 is a cross-sectional view illustrating a connection structure according to the fourth arrangement.

In the present arrangement, the side surface of the upper side of the plug 25 is covered with an interlayer insulating film (upper portion insulating film) 23, the side surface of the lower side lower than the upper side of the plug is covered with an interlayer insulating film (lower portion insulating film) 21, and the side surface between the side surface of lower side and the side surface of upper side of the plug 20 is covered with an interlayer insulating film (intermediate insulating film) 22. That is, although the side surface of the plug 20 in the first to third arrangements is covered with the interlayer insulating film 21 and the interlayer insulating film 22, the side surface of the plug 20 is further covered with the interlayer insulating film 23 in the present arrangement.

Hereafter, the connection structure of the present arrangement will be further explained in accordance with a manufacturing method of the connection structure.

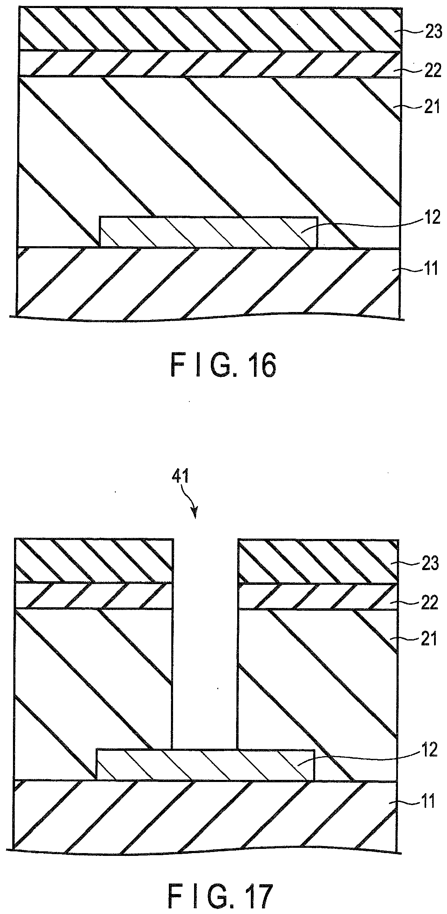

After the process shown in FIG. 2 of the first arrangement, the interlayer insulating film 23 is formed on the interlayer insulating film 22 as shown in FIG. 16.

Subsequently, as shown in FIG. 17, a first through hole 41 communicating with the interconnection 12 is formed in the interlayer insulating film 23, 22 and 21. A forming method of the first through hole 41 includes, for example, a process of forming a resist pattern on the interlayer insulating film 23 (lithography process), and a process of sequentially etching the interlayer insulating film 23, 22 and 21 using the resist pattern as a mask (etching process).

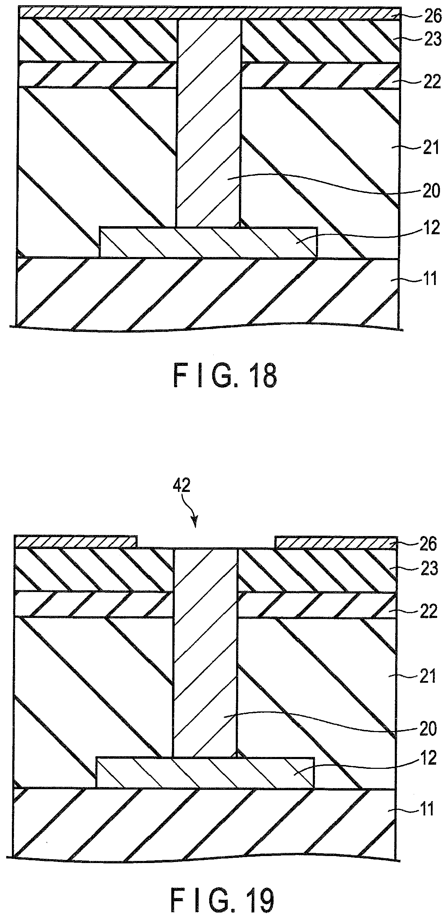

Subsequently, as shown in FIG. 18, the plug 20 is formed in the first through hole 41 that is shown in FIG. 17 such that the plug 20 fills the first through hole 41, and then the amorphous silicon germanium layer 26 is formed on the plug 20 and the interlayer insulating film 23. As described in the process of FIG. 3, the upper surface of the plug 20 and the upper surface of the interlayer insulating film 2 form the flat surface. Consequently, in the present arrangement, the amorphous silicon germanium layer 26 is formed on the flat under layer. In the first to third arrangements, the amorphous silicon germanium layer 26 is formed on the under layer having a concave (recessed) portion (e.g., FIG. 6).

Subsequently, as shown in FIG. 19, a second through hole 42 communicating with the plug 20 is formed in the amorphous silicon germanium layer 26. The second through hole 42 is formed to expose the upper surface of the plug 20 and a surface of the interlayer insulating film 23 near the periphery of the upper surface of the plug 20. The shape of the amorphous silicon germanium layer 26 of the present arrangement is different from the shapes of the amorphous silicon germanium layers 26 of the first to third arrangements. Because the under layer (plug 20, interlayer insulating film 23) of the amorphous silicon germanium layer 26 of the present arrangement is flat, whereas the under layers of the amorphous silicon germanium layers 26 of the first to third arrangements have concave (recessed) portions.

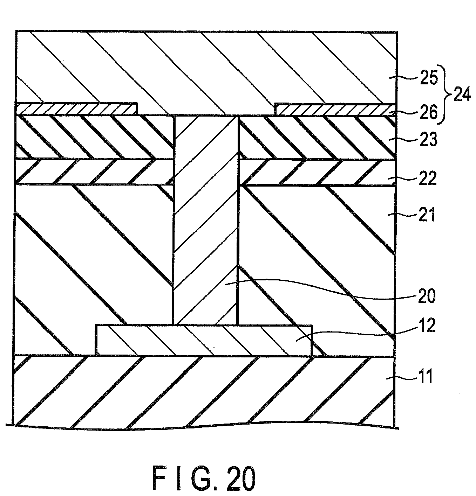

Subsequently, as shown in FIG. 20, the polycrystalline silicon germanium layer 25 is formed on the plug 20, the interlayer insulating film 23 and the amorphous silicon germanium layer 26 such that the amorphous silicon germanium layer 26 fills the second through hole 42 that is shown in FIG. 19.

After that, a hard mask (not shown) is formed on the polycrystalline silicon germanium layer 25, and then the polycrystalline silicon germanium layer 25 and the amorphous silicon germanium layer 26 are sequentially etched by using the hard mask as a mask, thereby obtaining the connection structure that is shown in FIG. 15.

### (Fifth Arrangement)

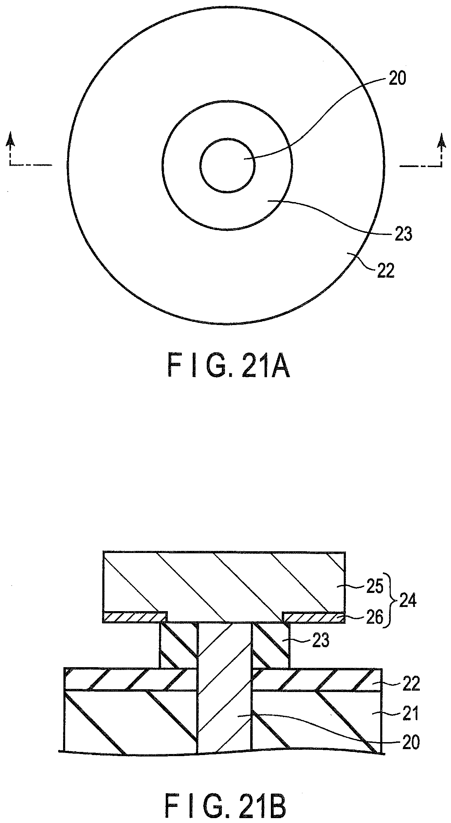

FIGS. 21A and 21B are a plane view and a cross-sectional view illustrating a connection structure according to the fifth arrangement, respectively. FIG. 21B is the cross-sectional view along the line chain line of FIG. 21A.

The present arrangement is different from the fourth arrangement in that the interlayer insulating film 23 is arranged inner side of the interlayer insulating film 22 when viewed from above the plug 20. Consequently, the area of the interlayer insulating film 23 is smaller than the area of the interlayer insulating film 21.

The connection structure of the present arrangement is obtained, for example, by employing a process in which the outer portion of the interlayer insulating film (sacrifice film) 23 is removed and the inner portion of the film 23 is remained after the process shown in FIG. 20. Such a process to remain the inner portion of the sacrifice film can be achieved, for example, by controlling gas flow or pressure of gas such as HF gas, or both the gas flow and the pressure.

### (Sixth Arrangement)

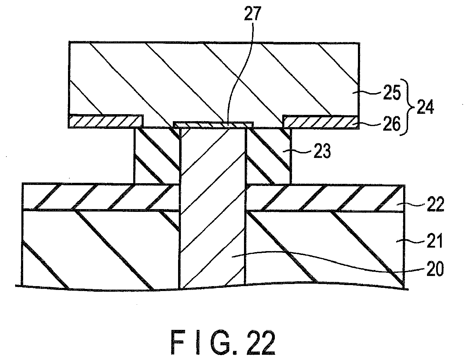

FIG. 22 is a cross-sectional view illustrating a connection structure according to the sixth arrangement.

The present arrangement is different from the fifth arrangement in that a barrier metal film 27 is provided, which covers the entire upper surface of the plug 20. That is, in the present arrangement, the barrier metal film 27 in the second arrangement is applied to the fifth arrangement.

The connection structure of the present arrangement is obtained in the following manner. In the process of FIG. 18, the barrier metal film 27 is formed before the amorphous silicon germanium layer 26 is formed, after that the amorphous silicon germanium layer 26 and polycrystalline silicon germanium layer 25 are sequentially formed, and then the outer portion of the interlayer insulating film (sacrifice film)23 is removed.

### (Seventh Arrangement)

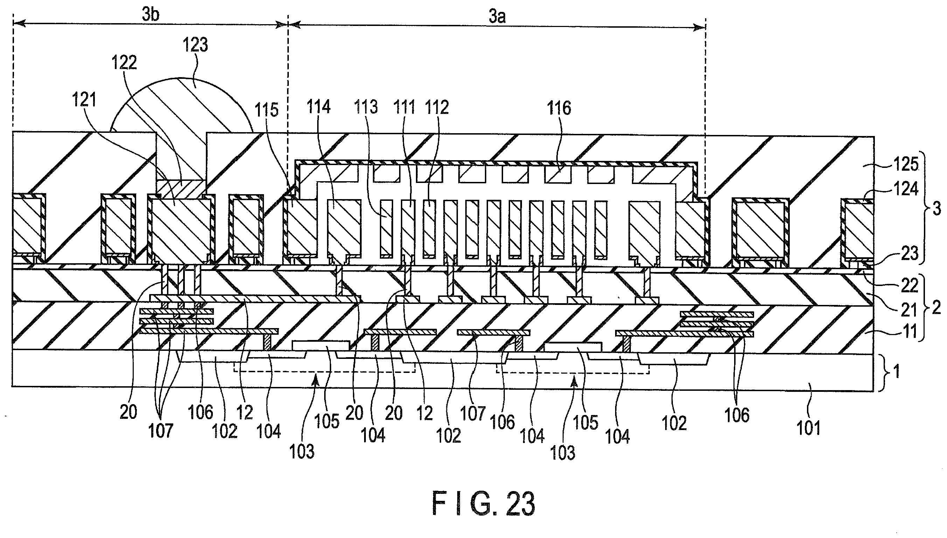

FIG. 23 is a cross-sectional view schematically illustrating an acceleration sensor according to the seventh arrangement.

The acceleration sensor of the present arrangement includes a substrate 1 including a CMOS integrated circuit, a multilevel interconnection layer 2 provided on the substrate 1, a MEMS device 3 provided on the multilevel interconnection layer 2. The MEMS device 3 is electrically connected to the substrate 1 through the multilevel interconnection layer 2.

The substrate 1 includes a silicon substrate 101, an isolation region 102 provide in the silicon substrate 101, and transistors 103 constituting in the CMOS integrated circuit. The transistor 103 includes source/drain regions 104 and a gate portion (gate insulating film, gate electrode).

The multilevel interconnection layer 2 includes plugs 20 and 106, interconnections 12 and 107, and interlayer insulating films 11, 21 and 22. The interlayer insulating film 11 has a structure in which insulating films (not shown) are stacked, however the structure is omitted for simplicity of the drawing. The interconnection and the plug in the uppermost layer of the multilevel interconnection layer 2 are denoted by reference numerals 12 and 20, respectively. The interconnection layer and plug arranged lower than the uppermost layer are denoted by reference numerals 107 and 106, respectively.

The MEMS device 3 includes a MEMS capacitor 3a, and a pad portion 3b.

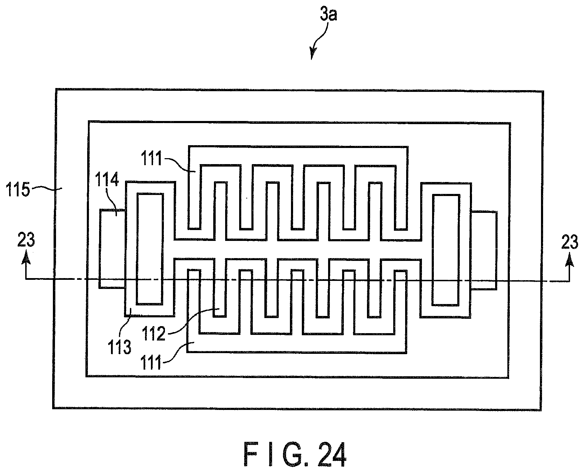

FIG. 24 is a plane view illustrating the MEMS capacitor 3a. The cross-sectional view of the MEMS capacitor 3a shown in FIG. 23 corresponds to a cross-sectional view along the line 23-23 of FIG. 24. The MEMS capacitor 3a includes a pair of comb-like fixed electrodes 111, and a comb-like movable electrode 112 of which position changes in accordance with a change of acceleration. The fixed electrode 111 is connected to the interconnection 12 through the plug 20, thereby fixing the fixed electrode 111.

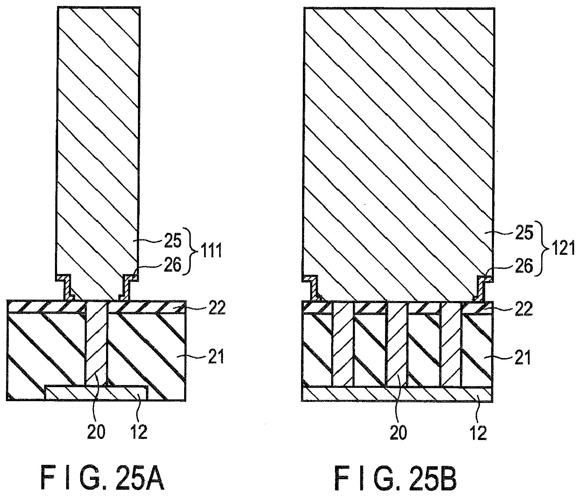

The connection structure between the fixed plug 111 and the plug 20 is simply illustrated in FIG. 23, however, the connection structure is more precisely shown in FIG. 25A. That is, the connection structure between the fixed plug 111 and the plug 20 employs the connection structure described in the first arrangement, which comprises the electrode 24 (polycrystalline silicon germanium layer 25, amorphous silicon germanium layer 26), and the plug 20. Consequently, the contact resistance between the fixed electrode 111 and the plug 20 is reduced, which results in a reduction of power consumption.

The fixed electrode 111 and the movable electrode 112 are arranged such that the comb-shaped portion of the fixed electrode 111 and the comb-shaped portion of the movable electrode 112 are engaged with each other and are spaced apart from each other by a gap. A pair of the fixed electrode and the movable electrode 12 form two capacitors. The difference between the capacitances of the two capacitors change in accordance with a change in acceleration. The CMOS integrated circuit is configured to detect the difference of capacitances between the two capacitor and to compute the acceleration based on the detection result.

The movable electrode 112 is connected to a first anchor portion 114 through a spring portion 113. The second anchor portion 115 is provided outside the first anchor portion 114. A ceiling portion (cap layer) 116 illustrated in FIG. 23 is provided above the fixed electrode 111, the movable electrode 112 and the spring portion 113. Through holes are provided in the ceiling portion 116. The ceiling portion 116 is supported by the second anchor portion 115.

The pad portion 3b includes an electrode 121 connected to the plug 20, a pad electrode 122 provided on the electrode 121, and a solder ball 123 provided on the pad electrode 122. A connection structure of the first electrode 112 and the plug 20 also employs the connection structure described in the first arrangement, which comprises the electrode 24 and the plug 20.

The connection structure between the electrode 121 and the plug 20 is simply depicted in FIG. 23, but is more precisely depicted in a cross-section view of FIG. 25B. That is, the connection structure between the electrode 121 and the plug 20 is achieved by using the connection structure between the electrode 24 (polycrystalline silicon germanium layer 25, amorphous silicon germanium layer 26) and the plug 20, which is explained in the first arrangement. Consequently, the contact resistance between the electrode 121 and the plug 20 is reduced. As a result, the power consumption is reduced.

Noted that, reference numerals 124 and 125 denote insulating films. The insulating film 124 is, for example, a silicon nitride film having about 1 to 5 µm thickness.

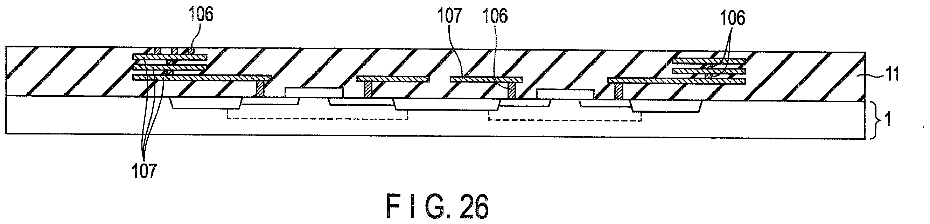

FIGS. 26 to 34 are cross-sectional views for explaining a method of manufacturing the acceleration sensor of the present arrangement.

First, as shown in FIG. 26, the substrate 2 including the CMOS integrated circuit is formed by well-known process, followed by forming the plug 106, the interconnection 107 and the interlayer insulating film 11 on the silicon substrate, which constitute the multilevel interconnection.

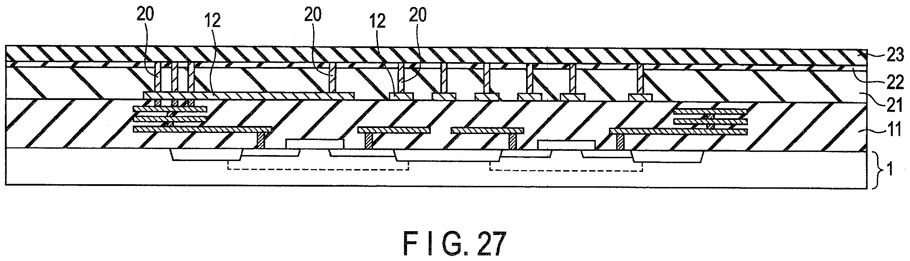

Subsequently, as shown in FIG. 27, the interconnection 12, the interlayer insulating films 21 and 22 are formed on the interlayer insulating film 11 in accordance with the process shown in FIG. 2 of the first arrangement, after that the plug 20 is formed in accordance with the process shown in FIG. 3 of the first arrangement, and then the interlayer insulating film 23 is formed in accordance with the process shown in FIG. 4 of the first arrangement. The thickness of the interlayer insulating film 23 is, for example, about 2 µm.

Note that, in the following figures (after FIG. 27), the portions below the interconnection 12 are omitted.

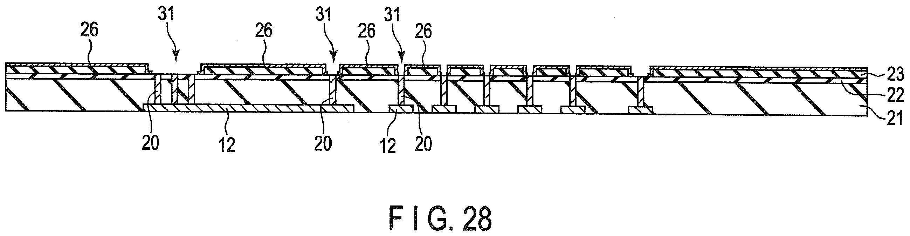

Subsequently, as shown in FIG. 28, a through hole 31 is formed in the interlayer insulating film 23 in accordance with the manufacturing method (FIG. 5) of the first arrangement, after that the amorphous silicon germanium layer 26 as a seed layer is formed on the entire surface in accordance with the manufacturing method (FIG. 6) of the first arrangement, and the amorphous silicon germanium layer 26 is patterned to expose the upper surface of the plug 2 in accordance with the manufacturing method (FIG. 7) of the first arrangement. The thickness of the amorphous silicon germanium layer 26 is, for example, about 100 nm.

Note that, the amorphous silicon germanium layer 26 in the through hole 31 has the shape shown in FIG. 7, however in FIG. 28, the amorphous silicon germanium layer 26 in the through hole 31 is simplified.

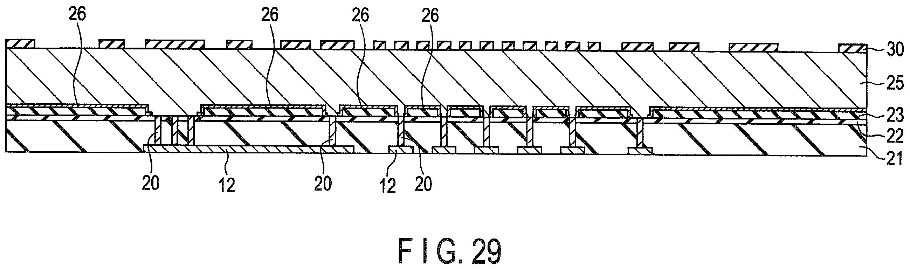

Subsequently, as shown in FIG. 29, the polycrystalline silicon germanium layer 25 is formed on the entire surface to fill the through hole 31 that is shown in FIG. 28 in accordance with the manufacturing method (FIG. 8) of the first arrangement, after that a the hard mask 20 is formed on the polycrystalline silicon germanium layer 25 in accordance with the manufacturing method (FIG. 8) of the first arrangement. The thickness of the polycrystalline silicon germanium layer 25 is, for example, 5 to 30 µm.

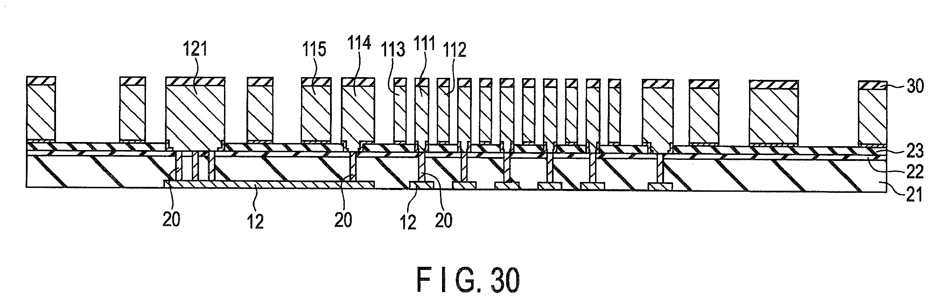

Subsequently, as shown in FIG. 30, the polycrystalline silicon germanium layer 25 and the amorphous silicon germanium layer 26 are sequentially etched by using the hard mask 30 as a mask in accordance with the manufacturing method (FIG. 9) of the first arrangement, thereby forming the fixed electrode 111, the movable electrode 112, the spring portion 113, the first anchor portion 114, the second anchor portion 115, and the electrode 121.

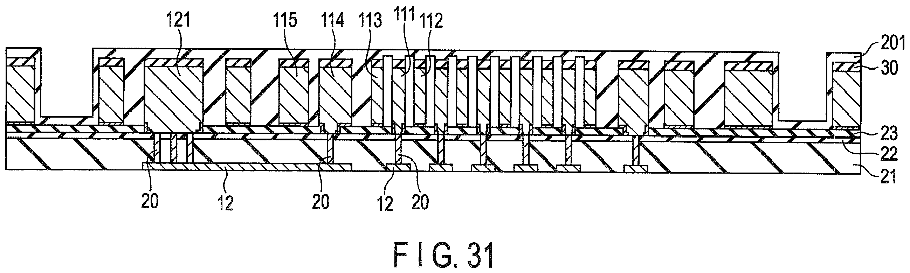

Subsequently, as shown in FIG. 31, a sacrifice film 201 made of silicon oxide is formed on the entire surface.

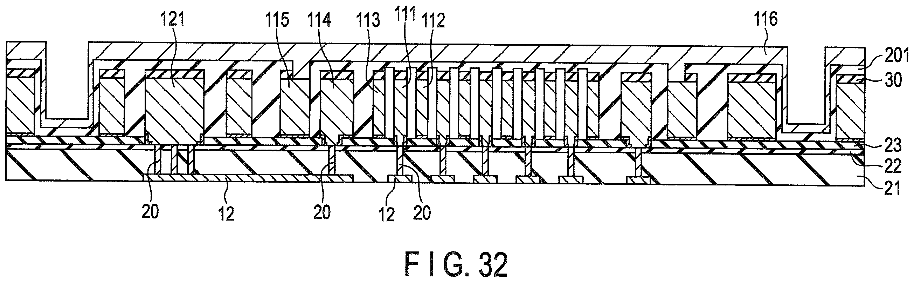

Subsequently, as shown in FIG. 32, a through hole (not shown) communicating with the second anchor portion 115 is formed in the sacrifice film 201 and the hard mask 30, after that a silicon germanium film 116, which is to be processed in to the ceiling portion, is formed to fill the through hole.

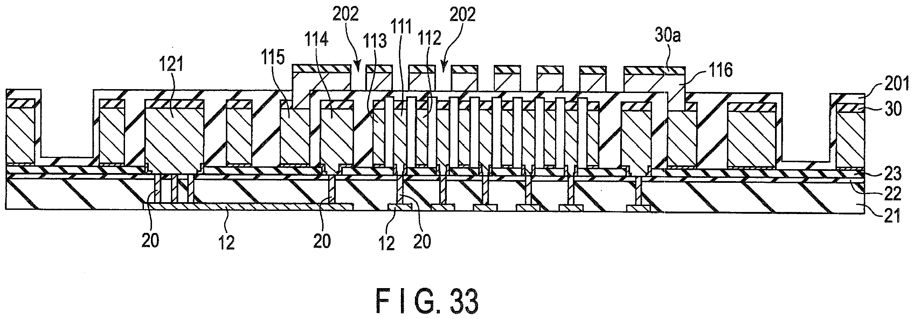

Subsequently, as shown in FIG. 33, a hard mask 30a made of silicon oxide is formed on the silicon germanium film 116, and the silicon germanium film 116 is etched by using the hard mask 30a as a mask, thereby forming the ceiling portion 116 having a through hole 202. The through hole 202 is used to introduce gas such as HF gas.

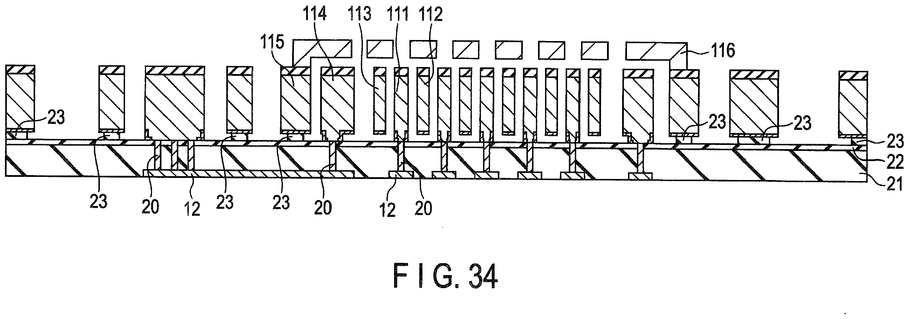

Subsequently, as shown in FIG. 34, dry process using the gas such as HF gas is conducted, thereby removing the hard mask 30, the hard mask 31 and the sacrifice film 201 which are made of silicon oxide, and removing a part of the interlayer insulating film 23 made of silicon oxide.

Thereafter performing well-known processes, and thus obtaining the acceleration sensor shown in FIG. 23.

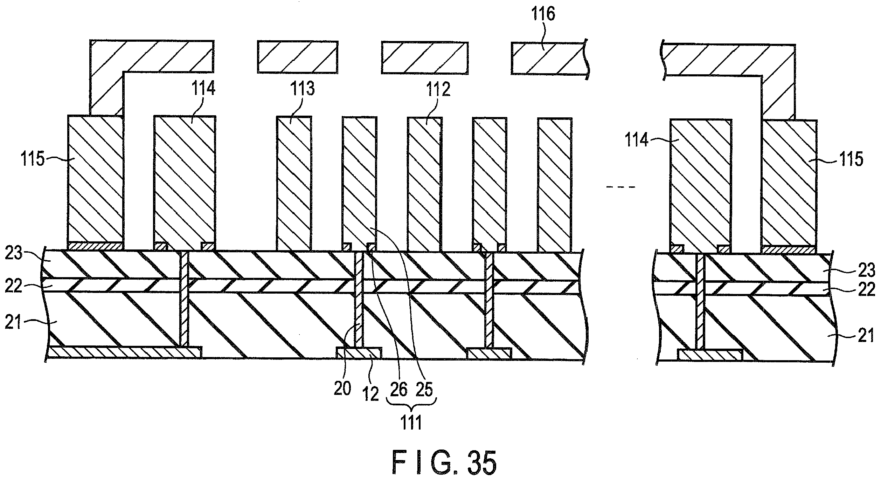

Noted that, in the present arrangement, the connection structure of the first arrangement is applied to the MEMS device, but any of the connection structures of the second to sixth arrangements may be applied to the MEMS device. FIG. 35 illustrates a cross-sectional view of a MEMS capacitor of the MEMS device to which the connection structure according to the fourth arrangement is applied.

Further, the present arrangement describes the acceleration sensor which detects acceleration based on the capacitance between the fixed electrode and the movable electrode of the MEMS capacitor, however the present arrangement is applicable to other sensor which detects other physical quantity based on the capacitance of the MEMS capacitor, for example a gyro sensor which detects angular velocity, or a pressure sensor which detects pressure. Still further, the connection structure according to the present arrangement is also applicable to devices other than the MEMS device.

Furthermore, the effect of the arrangement described above may be obtained even an electrode structure other than the above mentioned connection structure of the arrangements described above as long as the electrode structure in which the polycrystalline silicon germanium layer is in contact with at least part of the upper surface of the plug without intervention of the amorphous silicon germanium layer.

While certain arrangements have been described, these arrangements have been presented by way of example only, and are not intended to limit the scope of the claims. Indeed, the structures and methods described herein may be embodied in a variety of other forms; furthermore, various omissions, substitutions and changes in the form of the structures and methods described herein may be made.

The arrangements as described above include clauses below.

### Clause 1

A connection structure characterized by comprising:
a plug having conductivity;
a first insulating film covering a side surface of the plug; and
an electrode provided on an upper surface of the plug, and comprising a polycrystalline silicon germanium layer and an amorphous silicon germanium layer, the polycrystalline silicon germanium layer being in contact with at least part of the upper surface of the plug without an intervention of the amorphous silicon germanium layer.

### Clause 2

The connection structure of Clause 1, characterized in that the polycrystalline silicon germanium layer is directly in contact with an entire upper surface of the plug.

### Clause 3

The connection structure of Clause 1, characterized in that the polycrystalline silicon germanium layer is directly in contact with a part of the upper surface of the plug.

### Clause 4

The connection structure of Clause 3, characterized in that the amorphous silicon germanium layer is directly in contact with another part of the upper surface of the plug.

### Clause 5

The connection structure of any one of Clauses 1 to 4, characterized by further comprising a conductive film covering an entire upper surface of the plug, the polycrystalline silicon germanium layer is indirectly in contact with the at least part of the upper surface of the plug through the conductive film.

### Clause 6

The connection structure of Clause 5, characterized in that conductive film contains titanium.

### Clause 7

The connection structure of any one of Clauses 1 to 6, characterized in that the plug contains tungsten.

### Clause 8

The connection structure of any one of Clauses 1 to 7, characterized in that the first insulating film comprises an upper insulating film covering a side surface of an upper side of the plug, and a lower insulating film covering a side surface of a lower side of the plug, and a material of the upper insulating film is different from a material of the lower insulating film.

### Clause 9

The connection structure of Clause 8, characterized by further comprising a second insulating film provided on the first insulating film.

### Clause 10

The connection structure of any one of Clauses 1 to 7, characterized in that the first insulating film comprises an upper insulating film covering a side surface of an upper side of the plug, a lower insulating film covering a side surface of a lower side of the plug, and an intermediate insulating film covering a side surface between the lower side of the plug and the upper side of the plug, and
a material of the lower insulating film is different from a material of the intermediate insulating film, and the material of the intermediate insulating film is different from a material of the upper insulating film.

### Clause 11

The connection structure of Clause 10, characterized in that the upper insulating film is arranged inner side of the intermediate insulating film when viewed from above the plug.

### Clause 12

The connection structure of any one of Clauses 1 to 11, characterized by further comprising an interconnection provided below the plug and electrically connected to the plug.

### Clause 13

A method of manufacturing a connection structure, the method characterized by comprising:
sequentially forming an intermediate insulating film and an upper insulating film on a lower insulating film;
forming a first through hole in the lower insulating film, the intermediate insulating film and the upper insulating film;
forming a plug in the first through hole;
forming an amorphous silicon germanium layer on the upper insulating film and the plug;
forming a second through hole in the amorphous silicon germanium layer, the second through hole communicated with the first plug; and
forming a polycrystalline silicon germanium layer on the plug and the amorphous silicon germanium layer, the polycrystalline silicon germanium layer filling the second through hole.

### Clause 14

The method of Clause 13, characterized in that a material of the lower insulating film is different from a material of the intermediate insulating film, and
the material of the intermediate insulating film is different from a material of the upper insulating film.

### Clause 15

The method of Clause 14, characterized by further comprising removing a part of the upper insulating film.

### Clause 16

The method of Clause 15, characterized in that removing the part of the upper insulating film is performed by using gas.

### Clause 17

The method of Clause 16, characterized in that the gas contains hydrogen fluoride.

### Clause 18

A sensor characterized by comprising:
a variable capacitance element including a first electrode and a second electrode;
a circuit configured to sense a predetermined physical property by detecting a change in capacitance between the first electrode and the second electrode;
a plug having conductivity configured to connect the circuit and the variable capacitance element each other;
an insulating film covering a side surface of the plug without covering an upper surface of the plug; and
a connection structure for connecting the first electrode and the plug, the connection structure being a connection structure of any one of Clauses 1 to 11.

### Clause 19

The sensor of Clause 18, characterized in that the variable capacitance element comprises a MEMS capacitor in which the first electrode is used as a fixed electrode and the second electrode is used as a movable electrode.

### Clause 20

The sensor of Clause 18 or 19, characterized in that the predetermined physical property includes acceleration, angular velocity, or pressure.

## Claims

1. A connection structure **characterized by** comprising:
a plug (20) having conductivity;
a first insulating film (21, 22) covering a side surface of the plug; and
an electrode (24) provided on an upper surface of the plug, and comprising a polycrystalline silicon germanium layer (25) and an amorphous silicon germanium layer (26), the polycrystalline silicon germanium layer being in contact with at least part of the upper surface of the plug without an intervention of the amorphous silicon germanium layer.

2. The connection structure of Claim 1, **characterized in that** the polycrystalline silicon germanium layer is directly in contact with an entire upper surface of the plug.

3. The connection structure of Claim 1, **characterized in that** the polycrystalline silicon germanium layer is directly in contact with a part of the upper surface of the plug.

4. The connection structure of Claim 3, **characterized in that** the amorphous silicon germanium layer is directly in contact with another part of the upper surface of the plug.

5. The connection structure of any one of Claims 1 to 4, **characterized by** further comprising a conductive film (27) covering an entire upper surface of the plug, the polycrystalline silicon germanium layer is indirectly in contact with the at least part of the upper surface of the plug through the conductive film.

6. The connection structure of any one of Claims 1 to 5, **characterized in that** the first insulating film comprises an upper insulating film covering a side surface of an upper side of the plug, and a lower insulating film covering a side surface of a lower side of the plug, and a material of the upper insulating film is different from a material of the lower insulating film.

7. The connection structure of Claim 6, **characterized by** further comprising a second insulating film provided on the first insulating film.

8. The connection structure of any one of Claims 1 to 5, **characterized in that** the first insulating film comprises an upper insulating film (22) covering a side surface of an upper side of the plug, a lower insulating film (21) covering a side surface of a lower side of the plug, and an intermediate insulating film covering a side surface between the lower side of the plug and the upper side of the plug, and
a material of the lower insulating film is different from a material of the intermediate insulating film, and the material of the intermediate insulating film is different from a material of the upper insulating film.

9. The connection structure of Claim 8, **characterized in that** the upper insulating film is arranged inner side of the intermediate insulating film when viewed from above the plug.

10. The connection structure of any one of Claims 1 to 9, **characterized by** further comprising an interconnection provided below the plug and electrically connected to the plug.

11. A method of manufacturing a connection structure, the method **characterized by** comprising:
sequentially forming an intermediate insulating film (22) and an upper insulating film (23) on a lower insulating film (21);
forming a first through hole (41) in the lower insulating film, the intermediate insulating film and the upper insulating film;
forming a plug (20) in the first through hole;
forming an amorphous silicon germanium layer (26) on the upper insulating film and the plug;
forming a second through hole (42) in the amorphous silicon germanium layer, the second through hole communicated with the first plug; and
forming a polycrystalline silicon germanium layer (25) on the plug and the amorphous silicon germanium layer, the polycrystalline silicon germanium layer filling the second through hole.

12. The method of Claim 11, **characterized in that** a material of the lower insulating film is different from a material of the intermediate insulating film, and
the material of the intermediate insulating film is different from a material of the upper insulating film.

13. The method of Claim 12, **characterized by** further comprising removing a part of the upper insulating film.

14. The method of Claim 13, **characterized in that** removing the part of the upper insulating film is performed by using gas.

15. The method of Claim 14, **characterized in that** the gas contains hydrogen fluoride.
